# FASCICULE DE BREVET EUROPEEN

(11) **EP 3 056 070 B1**
(45) Date de publication et mention de la délivrance du brevet: **04.03.2020**
(21) Numéro de dépôt: 14796807.7
(22) Date de dépôt: 09.10.2014
(51) Int. Cl.: H05K 7/14, H02M 7/00, H05K 3/32

(54) **MODULE ÉLECTRIQUE, SYSTÈME ÉLECTRIQUE COMPORTANT UN TEL MODULE ÉLECTRIQUE, PROCÉDÉS DE FABRICATION CORRESPONDANTS**
ELEKTRISCHES MODUL, ELEKTRISCHEN SYSTEM MIT DERARTIGEM ELEKTRISCHEN MODUL UND ZUGEHÖRIGE HERSTELLUNGSVERFAHREN
ELECTRIC MODULE, ELECTRIC SYSTEM COMPRISING SUCH AN ELECTRIC MODULE, AND CORRESPONDING PRODUCTION METHODS

(30) Priorité: 09.10.2013 FR 1359774
(43) Date de publication de la demande: 17.08.2016
(73) Titulaire: Valeo Siemens eAutomotive France SAS, 95800 Cergy (FR)
(72) Inventeur: GOVINDASSAMY, Valery, F-95800 Cergy (FR); SCHWARTZ, Christian, F-78110 Le Vésinet (FR); DENIOT, Roger, F-78300 Poissy (FR)
(74) Mandataire: Argyma
(86) Numéro de dépôt international: PCT/FR2014/052562
(87) Numéro de publication internationale: WO 2015/052441

(56) Documents cités:
- EP-A1- 2 131 481
- EP-A2- 2 023 473
- JP-A- 2004 190 547
- US-A1- 2005 083 665
- US-A1- 2009 309 684
- US-A1- 2012 320 645

## Description

### DOMAINE TECHNIQUE

La présente invention concerne en particulier le domaine de l'électronique de commande de puissance utilisant par exemple des composants électriques comportant du matériau ferromagnétique.

### ARRIÈRE-PLAN TECHNOLOGIQUE

Les composants électriques à base de matériau ferromagnétique sont généralement sensibles aux sollicitations mécaniques et/ou thermomécaniques. Ainsi, leur maintien mécanique doit être garanti le mieux possible. En outre, ces composants peuvent en fonctionnement rapidement monter en température, de sorte qu'ils doivent être refroidis au mieux.

Une technique connue de refroidissement consiste à plaquer le composant à refroidir contre une plaque d'aluminium.

C'est par exemple ce que décrit la demande de brevet américain publiée sous le numéro US 2008/0079145 A1. Ce document décrit en outre d'utiliser une colle conductrice thermique.

Ce type de colle présente en effet de nombreux avantages. Cependant, elle présente l'inconvénient de polymériser à haute température.

Or, les barres de connexion électrique actuelles intègrent souvent non seulement des composants électriques à base de matériau ferromagnétique, mais en outre des composants électriques dont des composants thermosensibles ne supportant pas la température de polymérisation de la colle.

Par ailleurs, le document EP 2 131 481 A1 concerne un compresseur électrique intégré pour véhicule automobile, dont la configuration spatiale est adaptée en vue de réduire l'encombrement suscité.

Le dispositif électrique décrit dans le document EP 2 131 481 A1 comporte un bus sur lequel sont notamment connectés des composants électriques.

En outre, le document US 2009/309684 A1 et le document US 2005/083665 A1 décrivent respectivement un transformateur et un convertisseur de puissance comprenant une plaque à laquelle est fixée au moins un composant électrique, l'ensemble étant par ailleurs fixé à une barre de connexion.

Il existe en conséquence un besoin pour un procédé de fabrication d'un module électrique permettant la fixation de deux types différents de composants électriques.

### RÉSUMÉ DE L'INVENTION

Il est proposé un procédé de fabrication d'un module électrique, caractérisé en ce qu'il comporte :
- la fixation d'au moins un premier composant électrique à une première plaque,
dans lequel la fixation de chaque premier composant électrique sur la première plaque comprend :
- le dépôt d'une colle entre le premier composant électrique et la première plaque, ladite colle ayant une température de polymérisation, et
- le chauffage de la colle à une température supérieure ou égale à la température de polymérisation de ladite colle, afin de polymériser la colle,
- l'assemblage (304), après polymérisation de la colle, de chaque premier composant électrique (108, 110) à une barre de connexion électrique (104) à laquelle au moins un second composant électrique (120) est déjà fixé, ledit au moins un deuxième composant électrique ayant une température de fonctionnement normale maximale inférieure à la température de polymérisation de la colle.

Grâce au procédé proposé, le ou les seconds composants ne risquent pas d'être détériorés par la fixation du ou des premiers composants.

De manière optionnelle, la fixation du premier composant électrique à la première plaque comporte le chauffage de la colle, par exemple à une température d'au moins 125°C, de préférence d'au moins 150°C, pour polymériser la colle.

De manière optionnelle, l'assemblage du premier composant électrique avec la barre de connexion électrique comprend la fixation du premier composant à la barre de connexion électrique. Ainsi la barre de connexion électrique, les premiers et seconds composants et la première plaque forment un module qui peut être manipulé de façon à être par exemple transporté d'un endroit à un autre.

De manière optionnelle, l'assemblage du premier composant électrique à la barre de connexion électrique comprend :
- le positionnement d'une première portion de la barre de connexion électrique sur le premier composant, à l'opposée de la première plaque, de sorte que le premier composant se retrouve entre la barre de connexion électrique et la première plaque,
- la fixation de la barre de connexion électrique à la première plaque par au moins une seconde portion de la barre de connexion, ladite seconde portion s'étendant depuis la première portion vers la première plaque.

De manière optionnelle, la barre de connexion électrique comporte un enrobage plastique autour d'au moins un conducteur électrique. En particulier, le ou les conducteurs électriques sont destinés à assurer l'alimentation électrique du second composant et/ou du premier composant.

De manière optionnelle, le second composant électrique est fixé à l'enrobage plastique, notamment par surmoulage de l'enrobage plastique sur le second composant et/ou par l'intermédiaire d'un organe de fixation.

De manière optionnelle, ladite seconde portion de la barre de connexion électrique est intégrale avec l'enrobage plastique.

De manière optionnelle, la première plaque est destinée à dissiper la chaleur générée par le ou les premiers composants lors de leur fonctionnement.

Il est également proposé un procédé de fabrication d'un système électrique, comportant :
- la fabrication d'un module électrique suivant un procédé selon l'invention,
- la fixation de la première plaque à une seconde plaque destinée à dissiper la chaleur du module électrique.

De manière optionnelle, un canal de circulation de liquide de refroidissement et un jour débouchant dans le canal sont ménagés dans la seconde plaque, et la première plaque est fixée à la seconde plaque de manière à recouvrir le jour, afin que le liquide de refroidissement entre en contact avec la première plaque.

De manière optionnelle, la première plaque est munie de projections destinées à s'étendre dans le jour après fixation de la première plaque à la seconde plaque.

Il est également proposé un module électrique caractérisé en qu'il comporte :
- une première plaque,
- une barre de connexion électrique,
- au moins un premier composant électrique assemblé à la barre de connexion électrique, chaque premier composant électrique étant en outre fixé à la première plaque par une colle polymérisée, la colle présentant une certaine température de polymérisation,
- au moins un second composant électrique fixé à la barre de connexion électrique, chaque second composant électrique présentant une température maximale de fonctionnement normal inférieure à la température de polymérisation de la colle.

Il est également proposé un système électrique caractérisé en ce qu'il comporte :
- un module électrique selon l'invention,
- une seconde plaque à laquelle la première plaque est fixée, la seconde plaque étant destinée à dissiper la chaleur du module électrique.

De manière optionnelle, le système électrique comporte en outre :
- un boîtier renfermant le module électrique, la seconde plaque formant une partie du boîtier, notamment un fond du boîtier.

De manière optionnelle, le système électrique comporte en outre :
- au moins un troisième composant électrique fixé à la seconde plaque indépendamment du module électrique.

### DESCRIPTION DES FIGURES

Des modes de réalisation de l'invention vont à présent être décrits à titre d'exemple uniquement, en référence aux figures suivantes.
La figure 1 représente, dans une vue en trois dimensions, un module électrique selon l'invention.
La figure 2 représente, dans une vue en coupe, un premier système électrique selon l'invention, comportant le module de la figure 1.
La figure 3 représente, sous la forme d'un schéma-blocs, les étapes d'un procédé de fabrication du premier système électrique de la figure 2.
La figure 4 représente, dans une vue en coupe, un second système électrique selon l'invention, comportant le module de la figure 1.
La figure 5 représente, dans une vue en coupe, un troisième système électrique selon l'invention, comportant le module de la figure 1.

### DESCRIPTION DÉTAILLÉE

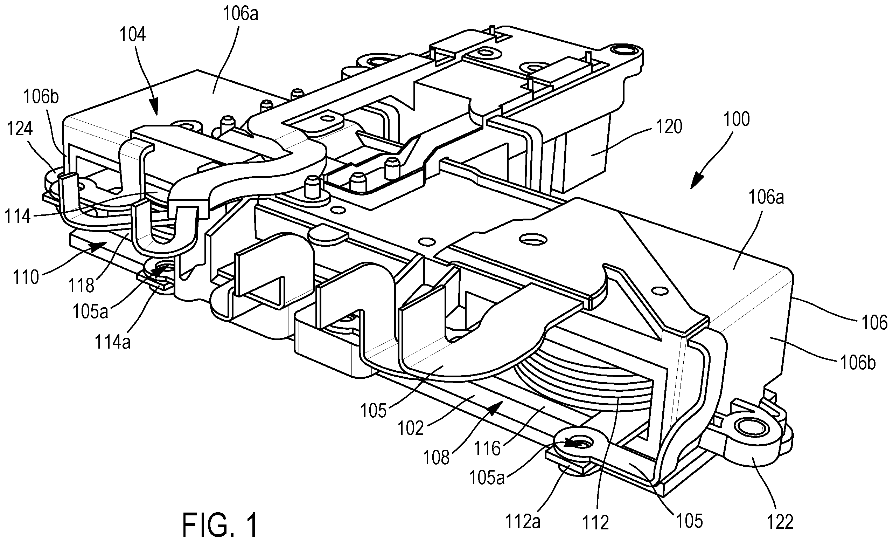

En référence à la figure 1, un module électrique 100 mettant en œuvre l'invention va à présent être décrit.

Le module électrique 100 comporte tout d'abord une plaque 102 ayant, comme cela sera expliqué par la suite, une fonction de support de composants électriques et de dissipation thermique de la chaleur générée par ces composants électriques. Comme cela sera également expliqué par la suite, la plaque 102 est destinée à être fixée sur une autre plaque et sera qualifiée de ce fait de « plaque intermédiaire ». La plaque intermédiaire 102 est de préférence en métal, par exemple en aluminium, et fait de préférence entre un et quinze millimètres d'épaisseur.

Le module électrique 100 comporte en outre une barre de connexion électrique 104, généralement appelée « bus bar » en anglais. La barre de connexion électrique 104 est destinée à convoyer de l'électricité, sous une tension de préférence comprise entre trois cents et cinq cents volts et d'une intensité de préférence comprises entre un et dix ampères. La barre de connexion électrique 104 comporte un enrobage plastique 106 autour d'au moins un conducteur électrique 105, notamment destiné à alimenter en énergie électrique des composants du module électrique 100.

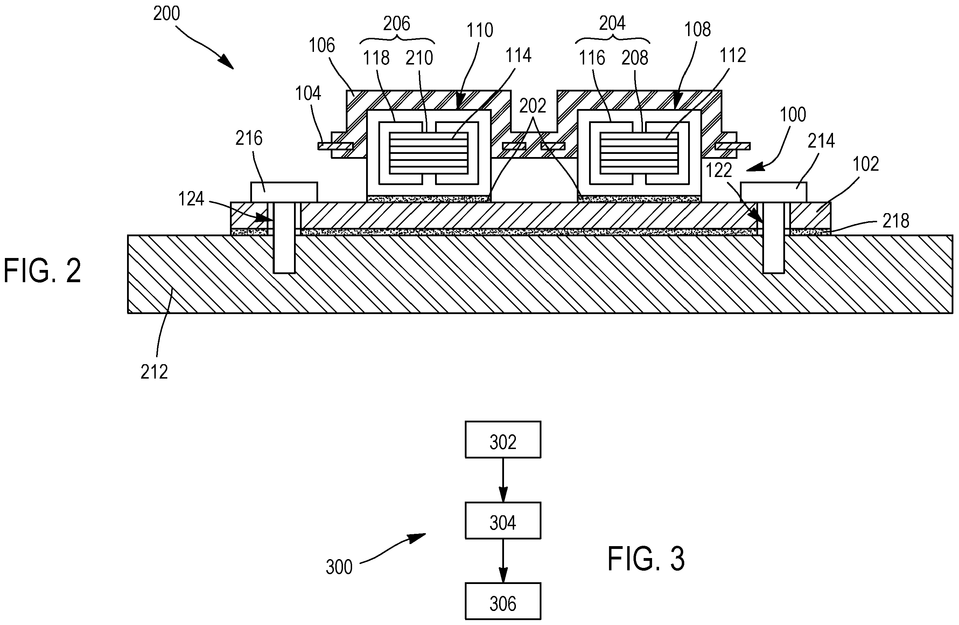

Le module électrique 100 comporte en outre deux composants électriques 108, 110. Ces composants 108, 110 seront qualifiés par la suite de « composants fragiles » car ils sont sensibles aux sollicitations mécaniques et/ou thermomécaniques, et doivent de ce fait être fermement fixés pour garantir leur bon fonctionnement en vibration ou lors de chocs. Dans l'exemple décrit, les composants fragiles 108, 110 comportent au moins une partie en matériau ferrite, qui est un matériau « fragile » dans le sens décrit précédemment. Chacun des deux composants fragiles 108, 110 comporte une bobine 112, 114 et un boîtier 116, 118. Les composants fragiles 108, 110 seront décrits plus en détails plus loin, en référence à la figure 2. Afin d'être fermement maintenus, les composants fragiles 108, 110 sont fixés à la plaque intermédiaire 102, sur une face supérieure de cette dernière, au moyen d'une colle polymérisée. Cette colle présente une température de polymérisation d'au moins 125°C, de préférence d'au moins 150°C. La colle est par exemple une colle silicone. La colle présente en outre de préférence une bonne conductivité thermique, par exemple comprises entre 1 et 6 W/m.K. La fixation des composants fragiles 108, 110 à la plaque intermédiaire 102 est réalisée de manière isolante électriquement.

Par ailleurs, les composants fragiles 108, 110 sont assemblés à la barre de connexion électrique 104 - c'est-à-dire maintenus en place par rapport à la barre de connexion électrique 104. Plus précisément, dans l'exemple décrit, une portion de la barre de connexion électrique 104, appelée portion couvrante 106a, est positionnée sur chaque composant fragile 108, 110, à l'opposée de la plaque intermédiaire 102 de manière à recouvrir les composants fragiles 108, 110. Ainsi, ces derniers se retrouvent enserrés entre la portion couvrante 106a de barre de connexion électrique 104 et la plaque intermédiaire 102. Afin de maintenir en place la barre de connexion électrique 104, et, de cette manière, les composants fragiles 108, 110, la barre de connexion électrique 104 présente en outre deux portions montantes 106b s'étendant depuis la portion couvrante 106a vers la plaque intermédiaire 102 et fixées à cette dernière. Dans l'exemple décrit, les portions montantes 106b sont des portions de l'enrobage 106 et sont donc intégrales avec ce dernier. Par ailleurs, de préférence, chaque portion montante 106b comprend à son extrémité fixée à la plaque intermédiaire 102 un picot (non visible) qui s'introduit dans une ouverture correspondante de la plaque intermédiaire 102, ce qui permet de positionner avec précision la barre de connexion 104 sur la plaque intermédiaire 102. Sur la figure 2, l'un des picots est positionné derrière la perforation 122 visible au premier plan.

Les composants fragiles 108, 110 peuvent ensuite être connectés électriquement au conducteur électrique 105, par exemple par l'intermédiaire d'une vis passant par des trous traversants 105a du conducteur 105 et des bornes 112a, 114a des composants fragiles 108, 110.

Le module électrique 100 comporte en outre au moins un autre composant électrique 120. Ce composant électrique 120 sera qualifié par la suite de « composant thermosensible » car il présente une température maximale de fonctionnement normal inférieure à la température de polymérisation de la colle. Le fonctionnement normal est celui permettant la réalisation de la fonction du module électrique, et, comme cela sera décrit plus loin, du système électrique comportant le module électrique 100. Par exemple la température maximale de fonctionnement normal est d'environ 100° C. Le composant thermosensible 120 est fixé à la barre de connexion électrique 104. La fixation peut assurer en outre une connexion électrique. Le composant thermosensible 120 est par exemple une capacité film, une capacité chimique, une capacité céramique, une résistance, un composant de mesure de courant ou de tension, un tore, ou bien un composant de type MOSFET (de l'anglais *« métal-oxide-semiconductor field-effect transistor »*)*.* De préférence, le composant thermosensible 120 est fixé à l'enrobage 106, notamment par surmoulage de l'enrobage 106 autour de ce composant thermosensible 120 et/ou par l'intermédiaire d'un organe de fixation.

Le module électrique 100 est en outre muni de perforations 122, 124 de passage de vis, ménagées dans l'exemple de la figure 1 dans l'enrobage plastique 106. En variante, comme illustré sur la figure 2, ces perforations pourraient être ménagées dans la plaque intermédiaire 102.

En référence à la figure 2, un premier système électrique 200 va à présent être décrit. Le premier système électrique 200 est par exemple un convertisseur de tension, comme notamment un convertisseur continu-continu ou bien un onduleur.

Le premier système électrique 200 comporte tout d'abord le module électrique 100 de la figure 1 (représenté schématiquement sur la figure 2 - en particulier les portions montantes 106b ne sont pas représentées). Sur cette figure, la colle polymérisée est visible et désignée par la référence 202. En outre, il est possible de voir que chaque composant fragile 108, 110 comporte un noyau ferromagnétique 204, 206 comprenant une partie interne 208, 210 autour de laquelle la bobine 112, 114 est enroulée, et une partie externe entourant la bobine 112, 114 de manière à former le boîtier 116, 118. Le noyau ferromagnétique 204, 206 est par exemple en ferrite.

Le premier système électrique 200 comporte en outre une autre plaque 212, appelée par la suite plaque principale, à laquelle la plaque intermédiaire 102 est fixée par une face inférieure, opposée à la face supérieure de la plaque intermédiaire 102. De préférence, la fixation est réalisée mécaniquement, c'est-à-dire au moyen de pièces mécaniques, par exemple à l'aide de vis 214, 216 dans les perforations 122, 124, par opposition à une fixation chimique comme de la colle. La plaque principale 212 a une fonction de support de la plaque intermédiaire 102 et de dissipation thermique de la chaleur convoyée par cette plaque intermédiaire 102. Pour améliorer la conduction thermique entre la plaque intermédiaire 102 et la plaque principale 212 une graisse thermique 218 est intercalée de préférence entre ces deux plaques. Dans l'exemple décrit, la plaque principale 212 est en métal, par exemple de l'aluminium. Elle peut être plus épaisse que la plaque intermédiaire 102.

En variante, la plaque principale 212 n'est pas en métal mais est une carte électronique comportant par exemple un substrat époxy. Ainsi, la plaque principale 212 est par exemple une plaque FR4 (de l'anglais *« Flame Résistant 4* ») ou IMS (de l'anglais *« Insulated Métal Substrates »*)*.*

Il est entendu que les composants du système électrique 200, en particulier les composants 108, 110, 120 du module électrique 100, participent à la réalisation de la fonction du système électrique 200, par exemple la fonction de convertisseur de tension.

En référence à la figure 3, un procédé de fabrication du premier système électrique 200 va à présent être décrit.

Au cours d'une étape 302, chacun des composants fragiles 108, 110 est fixé à la plaque intermédiaire 102. À cet effet, la colle 202 est déposée sur la plaque intermédiaire 102 et/ou sur chacun des composants fragiles 108, 110 et les composants fragiles 108, 110 sont maintenus contre la plaque intermédiaire 102. L'ensemble est alors passé dans un four pour être chauffé à une température au moins égale à la température de polymérisation de la colle 202, afin de polymériser cette dernière.

Au cours d'une étape 304, après la fixation des composants fragiles 108, 110 à la plaque intermédiaire 102, chacun des composants fragiles 108, 110 est assemblé à la barre de connexion électrique 104 à laquelle chaque composant thermosensible 120 est déjà fixé, par exemple par surmoulage de l'enrobage 106 ou par vissage comme cela à été décrit précédemment. Ainsi, le composant thermosensible 120 ne passe pas au four utilisé à l'étape 302. L'assemblage comporte par exemple le positionnement de la portion couvrante 106a de la barre de connexion 104 sur chaque composant fragile 108, 110, à l'opposée de la plaque intermédiaire 102, puis la fixation des portions montantes 106b à la plaque intermédiaire 102.

Au cours d'une étape 306, suite à l'étape 304, la plaque intermédiaire 102 est fixée à la plaque principale 212. À cet effet, la graisse thermique 218 est déposée sur la plaque principale 212 et la plaque intermédiaire 102 est posée sur la graisse thermique 218. Les vis 214, 216 sont alors vissées dans la plaque principale 212, au travers des perforations 122, 124.

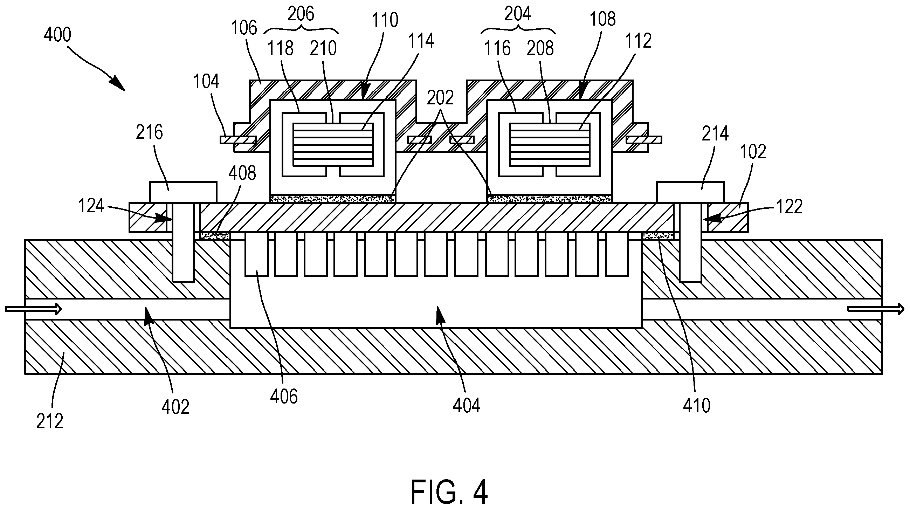

En référence à la figure 4, un deuxième système électrique 400 va à présent être décrit. Le deuxième système électrique 400 est par exemple un convertisseur de tension, comme notamment un convertisseur continu-continu ou bien un onduleur.

Le second système électrique 400 est identique au premier système électrique 200, des références identiques désignant des éléments identiques, sauf pour les différences qui vont à présent être décrites.

Un canal 402 de circulation de liquide de refroidissement est ménagé dans la plaque principale 212, de même qu'un jour 404 débouchant sur le canal 402.

La plaque intermédiaire 102 est fixée à la plaque principale 212 de manière à recouvrir le jour 404 et est en outre munie de projections 406 s'étendant dans le jour 404 et destinées à être en contact avec le liquide de refroidissement.

Par ailleurs, la graisse thermique 218 peut être remplacée par des joints d'étanchéité 408, 410 entre les deux plaques 102, 212.

Il est entendu que les composants du système électrique 400, en particulier les composants 108, 110, 120 du module électrique 100, participent à la réalisation de la fonction du système électrique 200, par exemple la fonction d'onduleur ou de convertisseur continu-continu.

Le second système électrique 400 peut être fabriqué au moyen du procédé 300, dans lequel la graisse thermique 218 peut être remplacée au moins en partie par les joints d'étanchéité 408, 410.

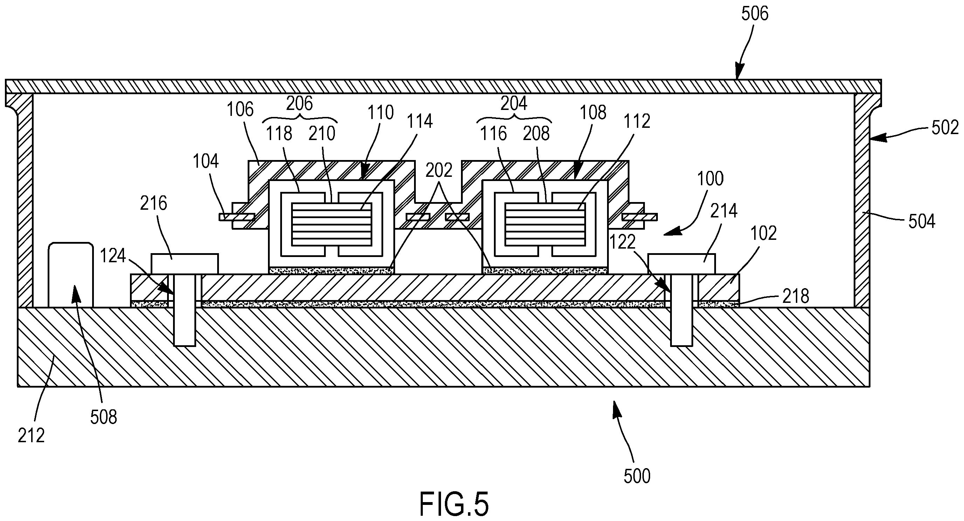

En référence à la figure 5, un troisième système électrique 500 va à présent être décrit. Le troisième système électrique 500 est par exemple un convertisseur de tension, comme notamment un convertisseur continu-continu ou bien un onduleur.

Le troisième système électrique 500 est identique au premier système électrique 200, des références identiques désignant des éléments identiques, sauf pour les différences qui vont à présent être décrites.

Le troisième système électrique 500 comporte tout d'abord, en outre des éléments déjà décrits, un boîtier 502 renfermant le module électrique 100.

Le boîtier 502 comporte tout d'abord la plaque principale 212 qui forme dans l'exemple décrit un fond du boîtier 502. Le boîtier 502 comporte en outre des parois latérales 504 s'élevant de la plaque principale 212. Le boîtier 502 comporte en outre un couvercle 506 destiné à reposer sur les parois latérales 504.

La plaque principale 212 présente une face interne, c'est-à-dire orientée vers l'intérieur du boîtier 502, sur laquelle la plaque intermédiaire 102 du module électrique 100 est fixée.

Le troisième système électrique 500 peut comporter en outre au moins un autre composant électrique 508, appelé par la suite « composant supplémentaire ». Chaque composant supplémentaire 508 est fixé non pas sur la plaque intermédiaire 102, mais par exemple directement sur la plaque principale 212, notamment sur sa face interne. Ainsi, le troisième composant 508 est fixé à la plaque principale 212 indépendamment du module électrique 100. En outre, la plaque principale 212 peut dissiper la chaleur générée par les composants supplémentaires. En variante, les composants supplémentaires 508 peuvent être fixés sur les parois latérales 504.

Le troisième système électrique 500 comporte en outre de préférence un système de refroidissement (par exemple similaire à celui de la figure 4) de la plaque principale 212, qui se trouve de préférence sur une face externe de la plaque principale 212, opposée à la face interne.

Il est entendu que les composants du système électrique 500, en particulier les composants 108, 110, 120 du module électrique 100 et le ou les composants supplémentaires 508, participent à la réalisation de la fonction du système électrique 200, par exemple la fonction d'onduleur ou de convertisseur continu-continu.

Le troisième système électrique 500 peut être fabriqué au moyen du procédé 300 auquel peut être ajouté une étape au cours de laquelle la barre de connexion électrique 104 est connectée électriquement au(x) composant(s) supplémentaire(s) 508.

D'après la description précédente, l'invention concerne un procédé de fabrication d'un module électrique 100, caractérisé en ce qu'il comporte :
- la fixation d'au moins un premier composant électrique 108, 110 à une première plaque 102, puis
- l'assemblage de chaque premier composant électrique 108, 110 à une barre de connexion électrique 104 à laquelle au moins un second composant électrique 120 est déjà fixé.

De manière optionnelle, la première plaque 102 est en métal, et comporte par exemple de l'aluminium ou du cuivre.

De manière optionnelle, chaque premier composant électrique 108, 110 comporte du matériau ferromagnétique.

De manière optionnelle, au moins un premier composant électrique 108, 110 comporte une bobine 112, 114 enroulée autour du matériau ferromagnétique.

De manière optionnelle, la colle 202 est une colle silicone.

De manière optionnelle, le ou les seconds composants 120 comportent au moins l'un parmi : une capacité film, une capacité chimique, une capacité céramique, une résistance, un composant de mesure de courant ou de tension, un tore et un composant de type MOSFET.

De manière optionnelle, chaque portion montante 106b comprend à son extrémité fixée à la première plaque 102 un picot qui s'introduit dans une ouverture correspondante de la première plaque 102, en particulier pour maintenir en prise la barre de connexion électrique 104 avec la première plaque 102. Ainsi la barre de connexion électrique 104, les premiers et seconds composants 108, 110, 120 et la première plaque 102 forment un module qui peut être manipulé de façon à être par exemple transporté d'un endroit à un autre.

De manière optionnelle, la fixation de la première plaque 102 à la seconde plaque 212 est réalisée mécaniquement, par exemple à l'aide de vis 214, 216.

De manière optionnelle, le troisième composant 508 est en outre connecté électriquement à la barre de connexion électrique 104 du module électrique 100.

De manière optionnelle, le boîtier 502 renferme en outre le ou les troisièmes composants électriques 508.

De manière optionnelle, le module électrique 100 et le ou les troisièmes composants électriques 508 sont fixés à la seconde plaque 212 sur une même face de la seconde plaque 212.

De manière optionnelle, le système électrique 200, 400, 500 forme un convertisseur de tension, par exemple un onduleur ou un convertisseur continu-continu.

L'invention concerne en outre un système électrique caractérisé en ce qu'il comporte :
- un module électrique comprenant :
- une première plaque 102,
- une barre de connexion électrique 104,
- au moins un premier composant électrique 108, 110 assemblé à la barre de connexion électrique 104, chaque premier composant électrique 108, 110 étant en outre fixé à la première plaque par une colle polymérisée 202, la colle 202 présentant une certaine température de polymérisation,
le système électrique comportant en outre une seconde plaque 212 à laquelle la première plaque 102 est fixée, la seconde plaque 212 étant destinée à dissiper la chaleur du module électrique 100.

Dans le module électrique 100, le premier composant 108, 110 est fixé à la première plaque 102. En particulier, la première plaque 102 a un encombrement juste suffisant pour recevoir le ou les premiers composants 108, 110. Ainsi, seuls la première plaque 102 et le ou les premiers composants 108, 110 ont été introduits dans un four pour parvenir à une polymérisation de la colle 202. Il n'a pas été nécessaire d'introduire l'ensemble du système électrique dans le four. L'inertie en montée de température a pu être limitée et la colle 202 se polymérisé plus rapidement. Le système électrique selon l'invention est donc fabriqué plus simplement et rapidement que dans l'art antérieur. Ce système électrique peut comprendre l'une quelconque des caractéristiques décrites précédemment qui lui sont compatibles.

En outre, comme cela est apparent à la lecture de la description précédente, l'invention permet la fixation de deux types différents de composants électriques, en particulier des composants fragiles devant être fixés par polymérisation à haute température, et des composants thermosensibles ne supportant pas cette haute température.

En outre, comme la polymérisation de la colle entre les composants et la plaque intermédiaire est réalisée avant la fixation de la barre de connexion électrique et des composants thermosensibles, il n'est pas nécessaire d'introduire la barre de connexion électrique et les composants thermosensibles dans le four. Ainsi, ce dernier peut être de petite taille. En outre, comme moins d'éléments sont dans le four, le chauffage est de durée raisonnable.

La présente invention n'est pas limitée aux modes de réalisations décrits précédemment, mais est au contraire définie par les revendications qui suivent. Il sera apparent à l'homme du métier que des modifications peuvent être apportées aux modes de réalisation décrits précédemment.

Par exemple, les plaques intermédiaire et principale pourraient être fixées l'une à l'autre avant que la barre de connexion électrique ne soit assemblée à chaque composant fragile.

En outre, la graisse thermique n'est qu'un exemple. Elle joue le rôle d'une interface thermique entre les deux plaques. À la place, il pourrait y avoir de l'air entre les deux plaques. La graisse peut être remplacée par toute autre pâte thermique comprenant des charges conductrices thermiques (charges céramique, alumine, argent) ou coussins prédécoupés en silicone, de l'époxy, du polyuréthane ou de l'acrylique avec les mêmes types de charge.

## Revendications

1. Procédé de fabrication d'un module électrique (100), **caractérisé en ce qu'**il comporte :
- la fixation (302) d'au moins un premier composant électrique (108, 110) à une première plaque (102)
dans lequel la fixation de chaque premier composant électrique sur la première plaque comprend :
- le dépôt d'une colle (202) entre le premier composant électrique (108, 110) et la première plaque (102), ladite colle (202) ayant une température de polymérisation, et
- le chauffage de la colle (202) à une température supérieure ou égale à la température de polymérisation de ladite colle (202), afin de polymériser la colle (202),
- l'assemblage (304), après polymérisation de la colle, de chaque premier composant électrique (108, 110) à une barre de connexion électrique (104) à laquelle au moins un second composant électrique (120) est déjà fixé, ledit au moins un deuxième composant électrique (120) ayant une température de fonctionnement normale maximale inférieure à la température de polymérisation de la colle (202).

2. Procédé de fabrication selon la revendication 1, dans lequel la fixation du premier composant électrique (108, 110) à la première plaque (102) comporte le chauffage de la colle (202), par exemple à une température d'au moins 125°C, de préférence d'au moins 150°C, pour polymériser la colle (202).

3. Procédé de fabrication selon les revendications 1 ou 2, dans lequel l'assemblage du premier composant électrique (108, 110) avec la barre de connexion électrique (104) comprend la fixation du premier composant (108, 110) à la barre de connexion électrique (104).

4. Procédé de fabrication selon les revendications 1 ou 2, dans lequel l'assemblage du premier composant électrique (108, 110) à la barre de connexion électrique (104) comprend :
- le positionnement d'une première portion (106a) de la barre de connexion électrique (104) sur le premier composant (108, 110), à l'opposé de la première plaque (102), de sorte que le premier composant (108, 110) se retrouve entre la barre de connexion électrique (104) et la première plaque (102),
- la fixation de la barre de connexion électrique (104) à la première plaque (102) par au moins une seconde portion (106b) de la barre de connexion (104), ladite seconde portion (106b) s'étendant depuis la première portion (106a) vers la première plaque (102).

5. Procédé de fabrication selon l'une quelconque des revendications 1 à 4, dans lequel la barre de connexion électrique (104) comporte un enrobage plastique (106) autour d'au moins un conducteur électrique (105).

6. Procédé de fabrication selon les revendications 3 et 5, dans lequel le second composant électrique (120) est fixé à l'enrobage plastique (106), notamment par surmoulage de l'enrobage plastique (106) sur le second composant (120) et/ou par l'intermédiaire d'un organe de fixation.

7. Procédé de fabrication selon les revendications 4 et 5, dans lequel ladite seconde portion (106b) de la barre de connexion électrique (104) est intégrale avec l'enrobage plastique (106).

8. Procédé de fabrication selon l'une quelconque des revendications 1 à 7, dans lequel la première plaque (102) est destinée à dissiper la chaleur générée par le ou les premiers composants (108, 110) lors de leur fonctionnement.

9. Procédé de fabrication d'un système électrique, comportant :
- la fabrication d'un module électrique (100) suivant un procédé selon l'une quelconque des revendications 1 à 8,
- la fixation de la première plaque (102) à une seconde plaque (212) destinée à dissiper la chaleur du module électrique (100).

10. Procédé de fabrication selon la revendication 9, dans lequel un canal (402) de circulation de liquide de refroidissement et un jour (404) débouchant dans le canal (402) sont ménagés dans la seconde plaque (212), et dans lequel la première plaque (102) est fixée à la seconde plaque (212) de manière à recouvrir le jour (404), afin que le liquide de refroidissement entre en contact avec la première plaque (102).

11. Procédé de fabrication selon la revendication 10, dans lequel la première plaque (102) est munie de projections (406) destinées à s'étendre dans le jour (404) après fixation de la première plaque (102) à la seconde plaque (212).

12. Module électrique (100) **caractérisé en ce qu'**il comporte :
- une première plaque (102),
- une barre de connexion électrique (104),
- au moins un premier composant électrique (108, 110) assemblé à la barre de connexion électrique (104), chaque premier composant électrique (108, 110) étant en outre fixé à la première plaque (102) par une colle polymérisée (202), la colle (202) présentant une certaine température de polymérisation,
- au moins un second composant électrique (120) fixé à la barre de connexion électrique (104), chaque second composant électrique (120) présentant une température maximale de fonctionnement normal inférieure à la température de polymérisation de la colle (202).

13. Système électrique (200 ; 400 ; 500) **caractérisé en ce qu'**il comporte :
- un module électrique (100) selon la revendication 12,
- une seconde plaque (212) à laquelle la première plaque (102) est fixée, la seconde plaque (212) étant destinée à dissiper la chaleur du module électrique (100).

14. Système électrique (500) selon la revendication 13, comportant en outre un boîtier (502) renfermant le module électrique (100), la seconde plaque (212) formant une partie du boîtier (502), notamment un fond du boîtier (502).

15. Système électrique (500) selon les revendications 13 ou 14, comportant en outre au moins un troisième composant électrique (508) fixé à la seconde plaque (212) indépendamment du module électrique (100).

## Patentansprüche

1. Verfahren zur Herstellung eines elektrischen Moduls (100), **dadurch gekennzeichnet, dass** es aufweist:
- das Befestigen (302) mindestens einer ersten elektrischen Komponente (108, 110) an einer ersten Platte (102), wobei die Befestigung jeder ersten elektrischen Komponente auf der ersten Platte umfasst:
- das Aufbringen eines Klebers (202) zwischen der ersten elektrischen Komponente (108, 110) und der ersten Platte (102), wobei der Kleber (202) eine Polymerisationstemperatur hat, und
- das Erhitzen des Klebers (202) auf eine Temperatur über oder gleich der Polymerisationstemperatur des Klebers (202), um den Kleber (202) zu polymerisieren,
- das Verbinden (304), nach Polymerisation des Klebers, jeder ersten elektrischen Komponente (108, 110) mit einer Stromschiene (104), an welcher mindestens eine zweite elektrische Komponente (120) bereits befestigt ist,
wobei die mindestens eine zweite elektrische Komponente (120) eine normale maximale Betriebstemperatur unter der Polymerisationstemperatur des Klebers (202) hat.

2. Herstellungsverfahren nach Anspruch 1, wobei die Befestigung der ersten elektrischen Komponente (108, 110) an der ersten Platte (102) das Erhitzen des Klebers (202) auf beispielsweise eine Temperatur von mindestens 125 °C, vorzugsweise von mindestens 150 °C, aufweist, um den Kleber (202) zu polymerisieren.

3. Herstellungsverfahren nach den Ansprüchen 1 oder 2, wobei die Verbindung der ersten elektrischen Komponente (108, 110) mit der Stromschiene (104) die Befestigung der ersten Komponente (108, 110) an der Stromschiene (104) umfasst.

4. Herstellungsverfahren nach den Ansprüchen 1 oder 2, wobei die Verbindung der ersten elektrischen Komponente (108, 110) an der Stromschiene (104) umfasst:
- das Positionieren eines ersten Abschnitts (106a) der Stromschiene (104) auf der ersten Komponente (108, 110) gegenüber der ersten Platte (102), so dass sich die erste Komponente (108, 110) zwischen der Stromschiene (104) und der ersten Platte (102) befindet,
- das Befestigen der Stromschiene (104) an der ersten Platte (102) durch mindestens einen zweiten Abschnitt (106b) der Stromschiene (104), wobei sich der zweite Abschnitt (106b) ab dem ersten Abschnitts (106a) zur ersten Platte (102) erstreckt.

5. Herstellungsverfahren nach einem der Ansprüche 1 bis 4, wobei die Stromschiene (104) einen Kunststoffmantel (106) um mindestens einen elektrischen Leiter (105) aufweist.

6. Herstellungsverfahren nach den Ansprüchen 3 und 5, wobei die zweite elektrische Komponente (120) am Kunststoffmantel (106) befestigt ist, insbesondere durch Overmolding des Kunststoffmantels (106) auf der zweiten Komponente (120) und/oder mit Hilfe eines Befestigungsorgans.

7. Herstellungsverfahren nach den Ansprüchen 4 und 5, wobei der zweite Abschnitt (106b) der Stromschiene (104) mit dem Kunststoffmantel (106) nahtlos ist.

8. Herstellungsverfahren nach einem der Ansprüche 1 bis 7, wobei die erste Platte (102) zum Ableiten der Wärme bestimmt ist, die von der oder den ersten Komponenten (108, 110) bei ihrem Betrieb erzeugt wird.

9. Verfahren zur Herstellung eines elektrischen Systems, aufweisend:
- das Herstellen eines elektrischen Moduls (100) nach dem Verfahren nach einem der Ansprüche 1 bis 8,
- das Befestigen der ersten Platte (102) an einer zweiten Platte (212), die zum Ableiten der Wärme von dem elektrischen Modul (100) bestimmt ist.

10. Herstellungsverfahren nach Anspruch 9, wobei ein Zirkulationskanal (402) von Kühlflüssigkeit und eine Öffnung (404), die in den Kanal (402) ausmündet, in der zweiten Platte (212) eingerichtet sind, und wobei die erste Platte (102) an der zweiten Platte (212) derart befestigt ist, dass die Öffnung (404) bedeckt ist, damit die Kühlflüssigkeit mit der ersten Platte (102) in Kontakt tritt.

11. Herstellungsverfahren nach Anspruch 10, wobei die erste Platte (102) mit Vorsprüngen (406) ausgestattet ist, die bestimmt sind, sich nach Befestigung der ersten Platte (102) an der zweiten Platte (212) in die Öffnung (404) zu erstrecken.

12. Elektrisches Modul (100), **dadurch gekennzeichnet, dass** es aufweist:
- eine erste Platte (102),
- eine Stromschiene (104),
- mindestens eine erste elektrische Komponente (108, 110), die mit der Stromschiene (104) verbunden ist, wobei jede erste elektrische Komponente (108, 110) ferner an der ersten Platte (102) durch einen polymerisierten Kleber (202) befestigt ist, wobei der Kleber (202) eine bestimmte Polymerisationstemperatur aufweist,
- mindestens eine zweite elektrische Komponente (120), die an der Stromschiene (104) befestigt ist, wobei jede zweite elektrische Komponente (120) eine normale maximale Betriebstemperatur unter der Polymerisationstemperatur des Klebers (202) aufweist.

13. Elektrisches System (200; 400; 500), **dadurch gekennzeichnet, dass** es aufweist:
- ein elektrisches Modul (100) nach Anspruch 12,
- eine zweite Platte (212), an welcher die erste Platte (102) befestigt ist, wobei die zweite Platte (212) zum Ableiten der Wärme von dem elektrischen Modul (100) bestimmt ist.

14. Elektrisches System (500) nach Anspruch 13, aufweisend ferner ein Gehäuse (502), welches das elektrische Modul (100) umschließt, wobei die zweite Platte (212) einen Teil des Gehäuses (502) bildet, insbesondere einen Boden des Gehäuses (502).

15. Elektrisches System (500) nach den Ansprüchen 13 oder 14, aufweisend ferner mindestens eine dritte elektrische Komponente (508), die unabhängig vom elektrischen Modul (100) an der zweiten Platte (212) befestigt ist.

## Claims

1. A method for production of an electric module (100), **characterized in that** it comprises:
- fixing (302) at least one first electrical component (108, 110) to a first plate (102),
wherein the fixing of each first electrical component to the first plate comprises:
- depositing a bonding compound (202) between the first electrical component (108, 110) and the first plate (102, said bonding compound (202)having a polymerization temperature, and
- heating the bonding compound (202) to a temperature greater than or equal to the polymerization temperature of said bonding compound, in order to polymerize the bonding compound (202),
- assembling (304), after polymerization of the bonding compound, each first electrical component (108, 110) to an electrical connecting bar (104) to which at least one second electrical component (120) is already fixed, said at least one second electrical component having a maximum normal operation temperature lower than the polymerization temperature of the bonding compound (202).

2. The production method as claimed in claim 1, in which the fixing of the first electrical component (108, 110) to the first plate (102) comprises the heating of the bonding compound (202), for example to a temperature of at least 125°C, preferably of at least 150°C, in order to polymerize the bonding compound (202).

3. The production method as claimed in either of claims 1 and 2, in which the assembly of the first electrical component (108, 110) with the electrical connecting bar (104) comprises fixing the first component (108, 110) to the electrical connecting bar (104).

4. The production method as claimed in either of claims 1 and 2, in which the assembly of the first electrical component (108, 110) with the electrical connecting bar (104) comprises:
- positioning a first portion (106a) of the electrical connecting bar (104) on the first component (108, 110), opposite to the first plate (102), such that the first component (108, 110) ends up between the electrical connecting bar (104) and the first plate (102),
- fixing the electrical connecting bar (104) to the first plate (102) by at least one second portion (106b) of the connecting bar (104), said second portion (106b) extending from the first portion (106a) to the first plate (102).

5. The production method as claimed in any one of claims 1 to 4, in which the electrical connecting bar (104) comprises a plastic coating (106) around at least one electrical conductor (105).

6. The production method as claimed in claims 3 and 5, in which the second electrical component (120) is fixed to the plastic coating (106), notably by overmolding of the plastic coating (106) over the second component (120) and/or by means of a fixing mechanism.

7. The production method as claimed in claims 4 and 5, in which said second portion (106b) of the electrical connecting bar (104) is integral to the plastic coating (106).

8. The production method as claimed in any one of claims 1 to 7, in which the first plate (102) is configured to dissipate the heat generated by the first component or components (108, 110) during their operation.

9. Method for production of an electrical system, comprising:
- fabricating an electric module (100) according to a method as claimed in any one of claims 1 to 8,
- fixing the first plate (102) to a second plate (212) configured to dissipate the heat from the electric module (100).

10. The production method as claimed in claim 9, in which a channel (402) for the circulation of coolant liquid and an access (404) opening into the channel (402) are formed in the second plate (212), and in which the first plate (102) is fixed to the second plate (212) in such a manner as to cover the opening (404), in order for the coolant liquid to come into contact with the first plate (102).

11. The production method as claimed in claim 10, in which the first plate (102) is equipped with projections (406) configured to extend into the opening (404) after the first plate (102) has been fixed to the second plate (212).

12. An electric module (100) **characterized in that** it comprises:
- a first plate (102),
- an electrical connecting bar (104),
- at least one first electrical component (108, 110) mounted onto the electrical connecting bar (104), each first electrical component (108, 110) being furthermore fixed to the first plate (102) by a polymerized bonding compound (202), the bonding compound (202) having a certain polymerization temperature,
- at least one second electrical component (120) fixed to the electrical connecting bar (104), each second electrical component (120) having a maximum normal operating temperature lower than the polymerization temperature of the bonding compound (202).

13. An electrical system (200; 400; 500) **characterized in that** it comprises:
- an electric module (100) as claimed in claim 12,
- a second plate (212) to which the first plate (102) is fixed, the second plate (212) being configured to dissipate the heat from the electric module (100).

14. Electrical system (500) as claimed in claim 13, furthermore comprising a housing (502) enclosing the electric module (100), the second plate (212) forming a part of the housing (502), notably a base of the housing (502).

15. Electrical system (500) as claimed in either of claims 13 and 14, furthermore comprising at least a third electrical component (508) fixed to the second plate (212) independently of the electric module (100).
